# EUROPEAN PATENT APPLICATION

(11) **EP 3 292 909 A1**
(43) Date of publication of application: **14.03.2018**
(21) Application number: 16382419.6
(22) Date of filing: 12.09.2016
(51) Int. Cl.: B01J 23/46, B01J 23/652, B01J 37/02, B01J 35/00, B01D 53/94, C23C 28/00, B01J 23/62, B01J 23/64, B01J 23/68, B01J 23/00, B01J 23/02, B01J 23/22, B01J 23/26, B01J 23/34, B01J 23/42, B01J 23/58, B01J 23/755

(54) **CATALYST COMPRISING FERROELECTRIC SUBSTRATE FOR REDUCTION OF NITROGEN OXIDES**

(71) Applicant: Repsol, S.A., 28045 Madrid (ES)
(72) Inventor: OLIVA MIÑANA, Fermín, 28935 Móstoles, Madrid (ES); FRAGA TRILLO, Luisa María, 28935 Móstoles, Madrid (ES); GUTIÉRREZ SERNA, Jaime, 28935 Móstoles, Madrid (ES); PÁEZ DUEÑAS, Antonio, 28935 Móstoles, Madrid (ES); MIRANDA SORIANO, Rodolfo, 28049 Madrid (ES); OTERO, Roberto, 28049 Madrid (ES); GRANADOS, Daniel, 28049 Madrid (ES); PERNA, Paolo, 28049 Madrid (ES); GUERRERO, Rubén, 28049 Madrid (ES)
(74) Representative: ABG Patentes, S.L.

(57) **Abstract**

The present invention refers to a catalyst device (1) comprising: a) a ferroelectric material substrate (2) comprising one first surface (2.1) opposed to a second surface (2.2); b) a conducting material layer (3) deposited on the first surface (2.1) of the ferroelectric material substrate (2), c) a catalyst material layer (4) deposited on the second surface (2.2) of the ferroelectric material substrate (2), said catalyst material layer comprising an outer surface (4.1), wherein the catalyst device is characterized by further comprising: d) a conducting material (5) covering between 10% and 75% of the outer surface (4.1) of the catalyst material layer (4), based on the total outer surface (4.1) of the catalyst material layer (4), and wherein the distance between any point in the outer surface (4.1) of the catalyst material layer (4) that is not covered by conducting material (5) and the closest point in the outer surface (4.1) of the catalyst material layer (4) that is covered with conducting material (5) is equal to or shorter than 1 mm. The invention also refers to the use of this catalyst device for reduction or elimination of nitrogen oxides, preferably from internal combustion engines.

## Description

### FIELD OF THE INVENTION

The present invention relates generally to a device for the catalytic reduction of nitrogen oxides (NOₓ), such as those contained in exhaust gases or emissions produced by automotive internal combustion engines.

### BACKGROUND

Ferroelectric materials are characterized by exhibiting spontaneous and stable polarization, which can be reoriented by applying an external electric field. Such electrically switchable nature of this polarization promoted the development of several ferroelectric devices, such as nonvolatile ferroelectric random access memories (FeRAM).

Other potential applications include tunable catalysts, in which a catalytically active surface is deposited on the surface of the ferroelectric material. By applying an external electrical field, both the magnitude and direction of the polarization can be changed, which in turn modulates the catalyst behavior. In patent US 8592767 B2, the inventors use DFT calculations to theoretically describe a ferroelectric material having a metallic film on one surface and a catalytically active material on the other opposing surface. The inventors suggest that the catalytic surface is capable of reducing nitrogen oxides to elemental nitrogen atoms, and calculate adsorption energies as a function of the polarization of the ferroelectric material for a series of gaseous molecules such as CO, O₂, NO and N₂.

Kevin Garrity et al. (Physical Review B 2013, 88(4), 045401) use DFT calculations to study the polarization effect on both the ferroelectric and metallic oxide catalytic layers. They studied a theoretical system consisting of a PbTiO₃ film functionalized with TiO₂ termination on a metal electrode, covered with a single layer of SrRuO₃ or SrO as catalytic layer. Selecting the metallic oxide RuO₂ as catalytic layer leads to unsatisfactory results due to poor formation stability of the catalytic layer. The authors conclude that by tuning the polarization direction, molecules of CO₂ can be reversibly bound to the catalytic surface.

In a recent publication in ACS Catalysis 2015, 5, 4537, Kakekhani A. and Ismail-Beigi S. use computational calculations to predict the feasibility of a class of catalysts comprising an epitaxial monolayer of a transition metal oxide on an oxide ferroelectric substrate in which reversing the ferroelectric polarization state switches the surface activity between strong and weak binding to the reactant/product species. In detail, the system comprises a RuO₂ or CrO₂ monolayer deposited on a PbO-terminated PbTiO₃ ferroelectric layer. However, these monolayers tend to suffer from atomic interdiffusion of Ru (or Cr) atoms into the PbTiO₃ ferroelectric layer. In this way, the authors propose including an intercalating SrTiO₃ layer between the ferroelectric and the catalytic layers to improve the stability of RuO₂ or CrO₂. The results point out to the successful catalytic cyclic conversion of several gas molecules such as NOₓ, CO₂, N₂ and O₂. In the particular case of nitrogen monoxide (NO) conversion, the calculations reveal that these molecules undergo dissociation at positive polarization, which allows nitrogen atoms to form nitrogen gas molecules. When the polarization is reversed, the oxygen atoms combine to form oxygen gas molecules.

None of these documents disclose experimental data, and thus no experimental technical drawbacks were tackled. Moreover, the theoretical systems do not involve an upper electrode and none of these prior art documents describe the envisioned method to vary the polarization of the ferroelectric film. The state of the art does not afford information about how to provide the catalyst system with an upper electrode that allows reversing the polarization of the ferroelectric material and, at the same time, allow the surface of the catalyst to be exposed to the gas molecules.

### SUMMARY OF THE INVENTION

In principle, an efficient catalyst surface should allow both strong binding with the reactants, and weak binding with the products to move the catalytic reaction forward. The compromise between these two effects is usually achieved by choosing a solid surface with a reactivity that balances these two effects. The present invention allows the reactivity of the surface to be tuned, in such a way that the adsorption of the reactants and the desorption of the products occurs in two different steps in a single device, by tuning the polarization of a ferroelectric material which in turn modifies the catalyst monolayer properties.

The inventors have surprisingly found an unexpected lateral polarization propagation in the ferroelectric material even at micrometer distances (e.g > 25 µm). This allows a large region of the catalyst surface to be exposed, thus accessible, to reactant molecules. Therefore, the present invention provides a very efficient catalyst device, with an upper electrode that allows efficiently reversing the polarization of the ferroelectric material while, at the same time, maintaining sufficient surface of the catalyst to be exposed to the reactant molecules.

Accordingly, in a first aspect, the invention is directed to a catalyst device (1) comprising:
a) a ferroelectric material substrate (2) comprising one first surface (2.1) opposed to a second surface (2.2);
b) a conducting material layer (3) deposited on the first surface (2.1) of the ferroelectric material substrate (2),
c) a catalyst material layer (4) deposited on the second surface (2.2) of the ferroelectric material substrate (2), said catalyst material layer (4) comprising an outer surface (4.1);
wherein the catalyst device is characterized by further comprising: d)
a conducting material (5) covering between 10% and 75% of the outer surface (4.1) of the catalyst material layer (4), based on the total outer surface (4.1) of the catalyst material layer (4), and wherein the distance between any point in the outer surface (4.1) of the catalyst material (4) layer that is not covered by conducting material (5) and the closest point in the outer surface (4.1) of the catalyst material (4) layer that is covered with conducting material (5) is equal to or shorter than 1 mm.

The inventors have observed that a catalyst device as defined above allows reducing NOₓ molecules. In particular, it has been observed that under negative polarization NO molecules adsorb to the catalyst surface and decompose into atomic O and N more efficiently than under positive polarization. On the other hand, by increasing the temperature, molecular nitrogen desorbs from the catalyst surface at a lower temperature for positive polarization than for negative polarization. Therefore, a catalytic cycle consisting of an initial period at negative polarization to decompose the NO molecules on the catalysts outer surface, followed by a second period at positive polarization to desorb N₂ molecules, can catalyze the reduction of NO much more efficiently than the catalysts in the absence of the polarization.

In another aspect, the invention relates to the use of the catalyst device as described above for reduction of nitrogen oxides, preferably nitrogen oxides from internal combustion engines, more preferably from internal combustion diesel engines.

In a further aspect, the invention is directed to a process for the preparation of the catalyst device of the invention.

### DESCRIPTION OF THE DRAWINGS

These and other characteristics and advantages of the invention will become clearly understood in view of the detailed description of the invention which becomes apparent from a preferred embodiment of the invention, given just as an example and not being limited thereto, with reference to the drawings.
Figures 1A and 1B are views of a catalyst device, in accordance with an embodiment of the present invention.
Figure 2: XPS spectra of RuOx films for different thickness values grown on PZT (0, 0.5, 1 and 1.5 nm).
Figure 3: a) XPS spectra of RuOx films for different thickness values grown on PZT, b) SEM image of PZT substrate without RuO₂ sputtered layer, c) SEM image of PZT substrate with RuO₂ sputtered layer,
Figure 4: a) Optical images of a catalyst device having a conducting material arranged in the form of a curvilinear grid and a square grid, b) Polarization cycle for different surface coverages.
Figure 5: a) XPS spectra as a function of the annealing treatments for a RuOx layer deposited on silicon as catalyst for the reduction of NO, b) TPD spectra for masses 28 and 14, c) XPS intensity bands for atomic N, total N and NO at different temperatures.
Figure 6: Normalized XPS spectra of positively and negatively polarized PZT samples.
Figure 7: a) XPS spectra for negatively-polarized samples at increasing temperature, b) XPS intensity bands for atomic N, total N and NO at different temperatures.
Figure 8: a) XPS spectra for a negatively-polarized PZT sample, b) XPS spectra for the same sample as in Figure 8 at positive polarization.

### DETAILED DESCRIPTION OF THE INVENTION

Unless defined otherwise, all technical and scientific terms used herein have the same meaning as commonly understood to one of ordinary skill in the art to which this disclosure belongs.

The term "ferroelectric material" is used herein to mean a material which possesses a spontaneous polarization which may be reversed or reoriented (also known as "switching") by the application of an electric field.

The term "conducting material" refers to an electrically conducting material, i.e. to any material that conducts electricity. Preferably, it can be selected from metals, semiconductors and conducting polymers.

The term "catalyst material" refers to catalytically active species. Preferably it refers to any material capable of promoting or facilitating the reaction of decomposition of nitrogen oxides to nitrogen and oxygen.

The term "outer surface of the catalyst material layer" refers to the surface of the catalyst material layer that is opposed to the surface of the catalyst material layer in contact with the ferroelectric material layer.

The term "regular pattern" is intended to mean an orderly arrangement of features and spaces between the features wherein along at least one direction each of the features are substantially the same size and shape and the spaces between the features are substantially the same distance.

The term "deposited on" in the context of a layer means that a first layer is arranged above or below a second layer, wherein the first and the second layer are in direct contact with each other.

The term "layer" as used herein refers to a structure that is substantially laminar in form.

In this specification, the term "covered by a conducting material" or "covered by the conducting material" in the context of the outer surface of the catalyst material layer means that the conducting material is deposited on that part or region of the outer surface of the catalyst material layer, whereas the term "free from conducting material" refers to the part or region of the outer surface of the catalyst material layer that is not covered by conducting material.

The term "upper electrode" is used to refer to the conducting material that covers part of the outer surface of the catalyst material layer.

As used herein, the terms "lateral dimension", "width" and "length" refers to a dimension measured parallel to the surface of the substrate.

The term "nitrogen oxides" include species such as NO, NO₂, N₂O, N₂O₃, N₂O₄ and N₂O₅, and mixtures thereof. Preferably, in the context of the present invention, it refers to NO, NO₂ and mixtures thereof. More preferably it refers to NO.

The present invention refers to a catalyst device (1) comprising:
a) a ferroelectric material substrate (2) comprising one first surface (2.1) opposed to a second surface (2.2);
b) a conducting material layer (3) deposited on the first surface (2.1) of the ferroelectric material substrate (2),
c) a catalyst material layer (4) deposited on the second surface (2.2) of the ferroelectric material substrate (2), said catalyst material layer (4) comprising an outer surface (4.1);
wherein the catalyst device is characterized by further comprising: d)
a conducting material (5) covering between 10% and 75% of the outer surface (4.1) of the catalyst material layer (4), based on the total outer surface (4.1) of the catalyst material layer (4), and wherein the distance between any point in the outer surface (4.1) of the catalyst material layer (4) that is not covered by conducting material (5) and the closest point in the outer surface (4.1) of the catalyst material layer (4) that is covered with conducting material (5) is equal to or shorter than 1 mm.

In order for a reaction to occur, the catalyst material or at least part of the catalyst material must be in close contact with the reagents. For this reason, it needs to be exposed, thus accessible to the reagents. Therefore, when reference is made to the outer surface of the catalyst material layer that is free from or not covered by conducting material, it means that it is not covered by conducting material or by any other material or layer and so it is directly exposed to the reagents of the reaction catalyzed by the catalyst material (i.e the gas molecules, such as nitrogen oxides).

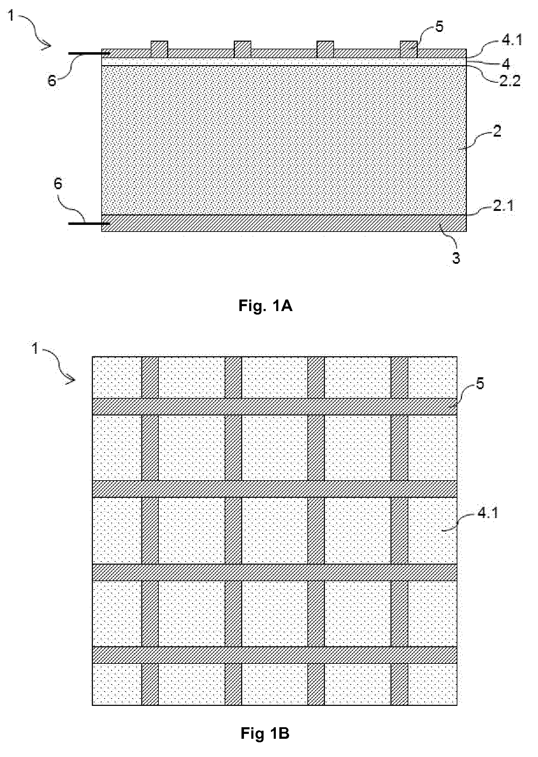

For illustrative purposes, a catalyst device in accordance with a particular embodiment of the present invention is shown in Figure 1.

In an embodiment, the conducting material layer (3) deposited on the first surface (2.1) of the ferroelectric material substrate (2) and the conducting material (5) covering between 10% and 75% of the outer surface (4.1) of the catalyst material layer (4) comprise electric connection means configured for being connected to an electric potential source (6).

In a particular embodiment, the ferroelectric material in the ferroelectric material substrate (2) is a perovskite. Examples of suitable ferroelectric materials include Pb(Zr,Ti)O₃ (PZT), PbTiO₃ (PLT), BaTiO₃, (Ba,Sr)TiO₃, SrTiO₃, LiNbO₃, LiTaO₃, (Pb,La)(Zr,Ti)O₃ (PLZT), BiFeO₃ and combinations thereof. Preferably, the ferroelectric material in the ferroelectric material substrate (2) is lead zirconate titanate (PZT).

In this regard, and contrary to the teachings of Zhou Y. et al, J. Phys. Chem. C 116, 12114 (2012), Fuks D. et al, Surface Science 499, 24 (2002) or F. Consandey F. and Madey T.E., Surface Review and Letters 8, 73 (2001), the inventors have surprisingly found that very thin layers of RuO₂ can be deposited on PZT, despite the lack of epitaxial relationship between the lattice of the catalyst and that of the ferroelectric substrate, and despite the rough surface of this ferroelectric material.

Preferably, the ferroelectric material substrate (2) is a ferroelectric material layer.

In a particular embodiment, the ferroelectric material layer has a thickness (i.e. the shortest distance between the first surface and the second surface of the ferroelectric material substrate) between 0.01 and 1000 micrometers, preferably between 1 and 500, or between 10 and 500 or between 50 and 500, more preferably between 100 and 400, even more preferably between 200 and 300 micrometers.

In a particular embodiment, the width and length of the ferroelectric material layer are independently between 1 and 20 millimeters, preferably between 5 and 15 millimeters, more preferably between 8 and 12 millimeters.

In an embodiment of the invention, the conducting material layer (3) deposited on the first surface (2.1) of the ferroelectric material substrate (2) is made of a metallic conducting material, such as pure metals, metal mixtures, metal alloys and stacks of different metal layers. Preferably, the metallic conducting material is selected from the group consisting of Au, Pt, Ag, Cu, Al, Zn, Ni, Cr, V, Ti, Pd, Rh, Ru, Fe and combinations thereof. More preferably, it is selected from Au, Pt, Ag, Cr, Cu and combinations thereof. Even more preferably, it is Au. In a particular embodiment, the conducting material layer (3) deposited on the first surface (2.1) of the ferroelectric material substrate (2) consists of a layer of Cr deposited on the first surface (2.1) of the ferroelectric material substrate (2) and a layer of Au deposited on the layer of Cr.

In an embodiment, the conducting material layer (3) deposited on the first surface (2.1) of the ferroelectric material substrate (2) has a thickness between 20 and 200 nanometers, preferably between 30 and 150 nanometers, more preferably between 50 and 100 nanometers.

Preferably, the conducting material layer deposited (3) on the first surface (2.1) of the ferroelectric material substrate (2) has substantially the same width and length as the ferroelectric material substrate (2). That is, preferably said conducting material layer (3) covers substantially the entire first surface (2.1) of the ferroelectric material substrate (2).

In an embodiment of the invention, the catalyst material in the catalyst material layer (4) is a metal oxide, preferably a transition metal oxide. In another embodiment, the catalyst material in the catalyst material layer (4) is an oxide of a metal selected from the group consisting of Ru, Cr, Pt, Pd, Rh, Fe, Ni, V, Ti, Al, Mn, Ir, Zr, Sr, and combinations thereof. In an embodiment, the catalyst material in the catalyst material layer (4) is selected from RuO₂, CrO₂, Cr₂O₃, Al₂O₃, PtO₂, RhO₂, MnO₂, IrO₂, NiO₂, ZrO₂, V₂O₅, SrTiO₃, SrRuO₃, and combinations thereof. In a preferred embodiment, the catalyst material in the catalyst material layer (4) is selected from RuO₂ and CrO₂, more preferably it is RuO₂.

In a particular embodiment, the ferroelectric material in the ferroelectric material substrate (2) is PZT and the catalyst material in the catalyst material layer (4) is RuO₂.

In an embodiment, the catalyst material layer (4) deposited on the second surface (2.2) of the ferroelectric material substrate (2) has a thickness between 0.2 and 5 nanometers, preferably between 0.2 and 3 nanometers, more preferably between 0.3 and 2 nanometers.

Preferably, the catalyst material layer (4) deposited on the second surface (2.2) of the ferroelectric material substrate (2) has substantially the same width and length as the ferroelectric material substrate (2). That is, preferably the catalyst material layer (4) covers substantially the entire second surface (2.2) of the ferroelectric material substrate (2).

In an embodiment, the conducting material layer (3) deposited on the first surface (2.1) of the ferroelectric material substrate (2) and the catalyst material layer (4) deposited on the second surface (2.2) of the ferroelectric material substrate (2) have substantially the same width and length as the ferroelectric material substrate (2). That is, preferably said conducting material layer (3) and said catalyst material layer (4) cover substantially the entire first surface (2.1) and second surface (2.2), respectively, of the ferroelectric material substrate (2).

In an embodiment, the conducting material (5) covering between 10% and 75% of the outer surface (4.1) of the catalyst material layer (4) is a metallic conducting material, such as pure metals, metal mixtures, metal alloys and stacks of different metal layers. Preferably, the metallic conducting material is selected from the group consisting of Au, Pt, Ag, Cu, Al, Zn, Ni, Cr, V, Ti, Pd, Rh, Ru, Fe and combinations thereof. More preferably, it is selected from Au, Pt, Ag, Cr, Cu and combinations thereof. Even more preferably, it is Au. In a particular embodiment, the conducting material (5) covering between 10% and 75% of the outer surface (4.1) of the catalyst material layer (4) consists of a layer of Cr deposited on the outer surface (4.1) of the catalyst material layer (4) and a layer of Au deposited on the layer of Cr.

In an embodiment, the conducting material (5) covering between 10% and 75% of the outer surface (4.1) of the catalyst material layer (4) has a thickness between 20 and 200 nanometers, preferably between 30 and 150 nanometers, more preferably between 50 and 100 nanometers.

The outer surface (4.1) of the catalyst material layer (4) that is covered by conducting material (5) is between 10% and 75%, based on the total outer surface (4.1) of the catalyst material layer (4). Surprisingly, despite not covering the whole outer surface (4.1) of the catalyst material layer (4), and despite the size of the holes in the upper electrode, this conducting material (5) is capable of switching the polarization of the ferroelectric material substrate (2) beneath the outer surface (4.1) of the catalyst material layer (4) that is free from conducting material (5). This allows providing a very efficient catalyst device as large catalytically active regions are created.

Preferably, the outer surface (4.1) of the catalyst material layer (4) that is covered by conducting material (5) is between 10% and 65%, more preferably between 10% and 55%, even more preferably between 10% and 45%, based on the total outer surface (4.1) of the catalyst material layer (4).

In another embodiment, the outer surface (4.1) of the catalyst material layer (4) that is covered by conducting material (5) is between 20% and 75%, preferably it is between 20% and 65%, more preferably between 20% and 55%, even more preferably between 20% and 45%, based on the total outer surface (4.1) of the catalyst material layer (4).

Also, in the present invention, the outer surface (4.1) of the catalyst material (4) is characterized by having part of its surface free from conducting material (5). In this way, being free from conducting material (5) means that it is exposed and accessible to any chemical species.

The catalyst device of the invention is characterized because the distance between any point in the outer surface (4.1) of the catalyst material layer (4) that is free from conducting material (5) and the closest point in the outer surface (4.1) of the catalyst material layer (4) that is covered with conducting material (5) is equal to or shorter than 1 mm. Preferably, said distance is equal to or shorter than 800 micrometers, equal to or shorter than 500 micrometers, more preferably equal to or shorter than 100 micrometers.

In a particular embodiment, there is at least one point in the outer surface (4.1) of the catalyst material layer (4) that is free from conducting material (5) that is at a distance of at least 0.5 micrometers from the closest point in the outer surface (4.1) of the catalyst material layer (4) that is covered with conducting material (5). Preferably, said distance is at least 1 micrometers, preferably at least 5 micrometers, more preferably it is 10 micrometers.

In another embodiment, the conducting material (5) covering between 10% and 75% of the outer surface (4.1) of the catalyst material layer (4) is arranged in a regular pattern.

In a particular embodiment, the conducting material (5) covering between 10% and 75% of the outer surface (4.1) of the catalyst material layer (4) is arranged in the form of a grid, a spiral, a serpentine, a plurality of interconnected islands, a plurality of interconnected rows, a plurality of interconnected concentric circles, or a plurality of interconnected concentric polygons or a plurality of interconnected lines.

In a particular embodiment, the conducting material (5) covering between 10% and 75% of the outer surface (4.1) of the catalyst material layer (4) is arranged in a regular pattern in the form of a grid. In an embodiment, the conducting material (5) covering between 10% and 75% of the outer surface (4.1) of the catalyst material layer (4) is arranged in the form of a grid selected from a square grid, a rectangular grid, a triangular grid, a hexagonal grid, a diamond-shaped grid, a linear grid and a curvilinear grid. Preferably, it is arranged in the form of a square grid or a curvilinear grid, more preferably it is in the form of a square grid.

The grid comprises a plurality of grid wires and a plurality of open (not covered) areas between the grid wires. In an embodiment, the conducting material (5) covering between 10% and 75% of the outer surface (4.1) of the catalyst material layer (4) is arranged in the form of a grid wherein each of the areas of the outer surface (4.1) of the catalyst material layer (4) that is not covered by conducting material (5) has a surface between 1000 µm² and 4 mm², preferably between 2000 µm² and 4 mm², more preferably between 5000 µm² and 4 mm², even more preferably between 10000 µm² and 3 mm². That is, the area of each part or region of the outer surface (4.1) of the catalyst material layer (4) that is free from conducting material (5) is between 1000 µm² and 4 mm², preferably between 2000 µm² and 4 mm², more preferably between 5000 µm² and 4 mm², even more preferably between 10000 µm² and 3 mm².

In an embodiment, the width of the grid wires is between 0.05 µm and 1 mm, preferably between 0.5 µm and 0.5 mm, more preferably between 10 µm and 500 µm.

In another embodiment, the conducting material (5) covering between 10% and 75% of the outer surface (4.1) of the catalyst material layer (4) is arranged in the form of a plurality of interconnected islands, interconnected rows, interconnected concentric circles, interconnected lines and interconnected concentric polygons. Preferably, the distance between each island, row, concentric circle or concentric polygon, and its adjacent is between 0.2 µm and 2 mm, preferably between 0.5 µm and 2 mm, more preferably between 1.0 µm and 1.5 mm (centre-to-centre).

Another aspect is directed to the use of the catalyst device of the invention for reduction or elimination of nitrogen oxides (NOₓ). Preferably, nitrogen oxides from internal combustion engines, more preferably from internal combustion of diesel engines.

In a particular embodiment, the catalyst device of the invention is subjected to an electric field. As a result, the polarization of the ferroelectric material substrate is modulated and so the activity of the catalyst material. The reagent molecules (e.g. nitrogen oxides) can adsorb to the outer surface of the catalyst material layer that is free from conducting material in order for the reaction to proceed.

In a particular embodiment, the applied voltage is between 1 V and 2000 V, preferably between 1 V and 1000 V, more preferably between 1 V and 800 V.

Another aspect is directed to a process for the manufacture of the catalyst device of the invention. Said process comprises: (a) depositing a conducting material layer (3) onto the first surface (2.1) of the ferroelectric material substrate (2), (b) depositing a catalyst material layer (4) onto the second surface (2.2) of the ferroelectric material layer (2), said catalyst material layer (4) comprising an outer surface (4.1), and (c) covering between 10% and 75% of the outer surface (4.1) of the catalyst material layer (4) with a conducting material (5).

The conducting material layer (3), the conducting material (5) and the catalyst material layer (4) can be deposited by any known thin film manufacturing process, such as for example atomic layer deposition, chemical vapor deposition, physical vapor deposition, sputtering, pulsed laser deposition, thermal evaporation, electron-beam evaporation, electrodeposition, molecular beam epitaxy, chemical growth and chemical functionalization. In a particular embodiment, the conducting material layer (3), the conducting material (5) and the catalyst material layer (4) are deposited by sputtering, thermal evaporation and/or electron-beam evaporation.

In an embodiment, the conducting material layer (4) can be deposited onto the first surface (2.1) of the ferroelectric material substrate (2) by thermal evaporation, sputtering, physical vapor deposition or electron-beam evaporation.

In an embodiment, when the catalyst material in the catalyst material layer (4) is a metal oxide, the catalyst material layer (4) can be deposited onto the second surface (2.2) of the ferroelectric material layer (2) or a metal layer can be deposited onto the second surface (2.2) of the ferroelectric material layer (2) followed by oxidation.

In a particular embodiment, when the catalyst material in the catalyst material layer (4) is a metal oxide, a metal layer is deposited onto the second surface (2.2) of the ferroelectric material layer (2), preferably by sputtering (magnetron sputtering) or atomic layer deposition, and the metal layer is then thermally oxidized in the presence of oxygen.

In an embodiment, the conducting material (5) covering between 10% and 75% of the outer surface (2.2) of the catalyst material layer (2) is deposited by a process comprising lithography. In a particular embodiment, the conducting material (5) covering between 10% and 75% of the outer surface (2.2) of the catalyst material layer (2) is deposited by a process comprising lithography of the pattern followed by deposition of the conducting material (5), preferably by thermal evaporation, and posterior lift-off process.

### EXAMPLES

The present invention will now be described by way of examples which serve to illustrate the construction and testing of illustrative embodiments. However, it is understood that the present invention is not limited in any way to the examples below.

### Example 1. Manufacture of the catalyst device

A commercially available Pb[ZrₓTi₁₋ₓ]O₃ (PZT) substrate (PiMicos, GmbH) of squared dimensions 10x10 mm and 250 µm thickness was polarized inside a Teflon polarization cell, placed between two copper electrodes and applying a voltage of 1000 V for 12 hours. The polarization cell was homemade and allows applying electric potentials of 1000 V in air without dielectrical breakdown.

One side of the substrate is covered with a metallic back gate, by thermal evaporation of 10nm of Cr followed by 90nm of Au in a thermal evaporator (Univex300, Oerlikon) under high vacuum conditions (5x10-6mbar).

The opposite side of the substrate was subsequently submitted to magnetron sputtering of ruthenium. The substrate was placed in a molybdenum sample holder and the chamber pressure was reduced to 3 x 10⁻⁸ mbar. The ruthenium target (99,99% purity, Kurt Lesker Inc.) was bombarded with Argon at a pressure of 8.6 x 10⁻³ mbar and power of 18 W until a Ru layer of thickness 0.5 nm was deposited on the PZT substrate. The thin Ru layer was then oxidized by exposing the surface to 1000 L of O₂ at 300 K, 10⁻⁵ Torr for 100 s.

The following step concerns the fabrication of the conducting material that covers the catalyst outer surface by means of optical lithography. The sample was covered with 1.2 µm of a UV-sensitive photoresist (AZ 1512 HS, MicroChemicals) by spincoating at 5000 rpm. A soft baking step on a hotplate at 100 °C for 1 minute allowed solvent removal. The resist was exposed with the sought pattern using a Laser Writer (Heidelberg DWL66FS) equipped with a 405 nm laser (1.75 mW). The resin was subsequently developed using a suitable developer (AZ 1512 HS, MicroChemicals) for 1 minute and rinsed with deionized water. An additional step of oxygen plasma for 1 minute at 50 W may be applied to assure full removal of exposed resin motifs. The pattern was transferred by submitting the lithographed substrate to thermal evaporation under high vacuum (5x10⁻⁶mbar) (Univex 300, Oerlikon) of 10 nm of Cr followed by 40 nm of Au. Finally, the sample was submersed in acetone for resin lift-off.

### Example 2. RuO₂ catalyst surface characterization

The chemical composition and electronic structure of the catalyst surface were characterized by means of X-ray photoemission spectroscopy (XPS). This was achieved by placing the sample in an ultra-high vacuum chamber (4 x 10⁻¹⁰ mbar), irradiating the sample using monochromated aluminum K-alpha X-rays, and analyzing the energy of the photoemitted electrons with a semispherical analyzer at a pass energy of 20 eV. The core level spectra were fitted by combinations of Gaussian and Lorentzian curves, the binding energy (BE) being relative to the Fermi level.

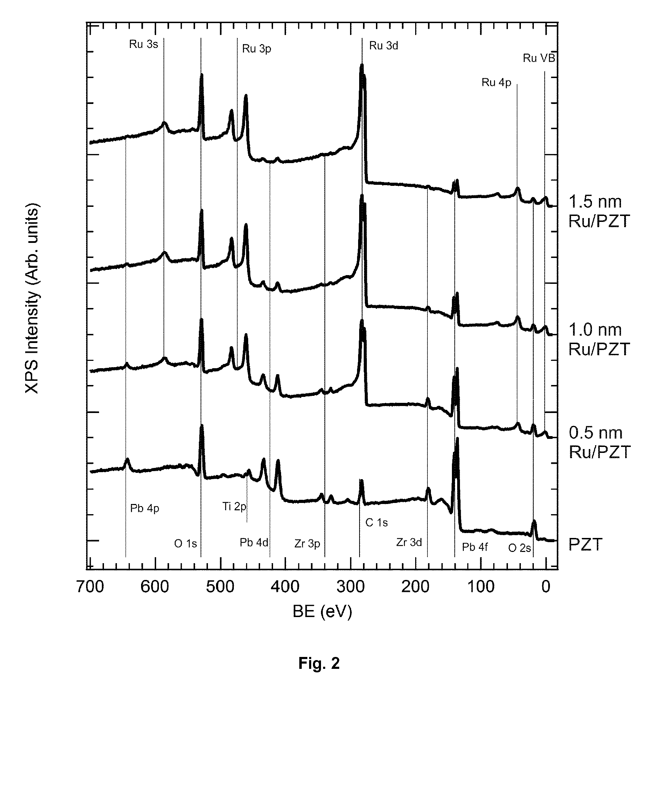

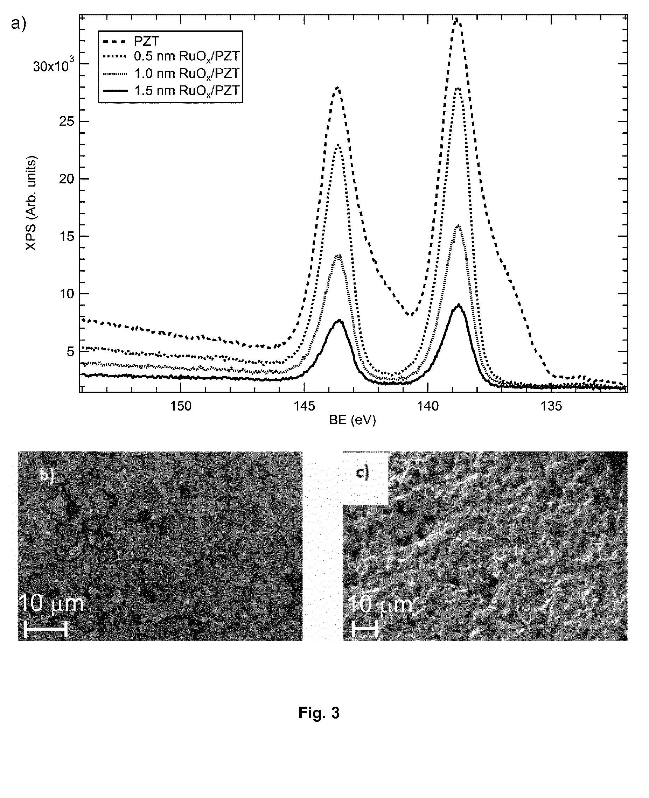

The XPS spectra for increasing thickness of RuO₂ on PZT (0, 0.5, 1 and 1.5 nm thickness) are shown in Figures 2 and 3a. As it can be seen in Figure 2 for the case of PZT without any RuO₂, the spectrum shows peaks corresponding to binding energies of Pb, Ti, Zr and O, as well as contamination from carbon. When RuO₂ is sputtered on the PZT surface, the XPS spectrum shows in addition to the PZT profile the binding energies associated to the core levels of ruthenium. No peaks from contaminants are observed.

Comparing the intensity of the peaks corresponding to the Pb 4f electronic level with increasing RuO₂ thickness shown in Figure 2 and in more detail in Figure 3a, it is seen that there is a decrease by a factor of 3 for a thickness of 1.5 nm, which is in good agreement with the mean free path for electrons at such energies. This observation is consistent with a homogeneous RuO₂ layer, in contrast with a layer with aggregated RuO₂ nanoparticles which would lead to a much smaller decrease in the intensity of the Pb 4f peaks. Supporting this observation are the SEM images of PZT substrates without (Figure 3b) and with (Figure 3c) a RuO₂ sputtered layer, which clearly shows that no RuO₂ aggregates are formed on the surface of PZT. The finding that a homogeneous metallic layer of atomic thickness could be grown on dielectric substrates at room temperature is surprising and was not expected.

### Example 3. Characterization of the polarization

For the regions of the outer surface of the catalyst material which are free from conducting material to be sensitive to the polarization of the ferroelectric material beneath it, the conducting material must be capable of switching the polarization of the regions which are free from it.

If the conducting material covers a fraction *f* of the catalyst outer surface, and the polarization switching only occurs on the regions which are covered by the conducting material, then the sample polarization is expected to decrease by a factor of 1-*f* when compared to a sample with a catalyst surface fully covered by conducting material. This result would demonstrate that the free from conducting material regions would not suffer from polarization switching and thus there would be no control over the active, catalytic regions of the sample. In contrast, if the polarization is extended to the free from conducting material regions of the PZT surface, then the measured polarization would decrease by a factor less than 1-*f*.

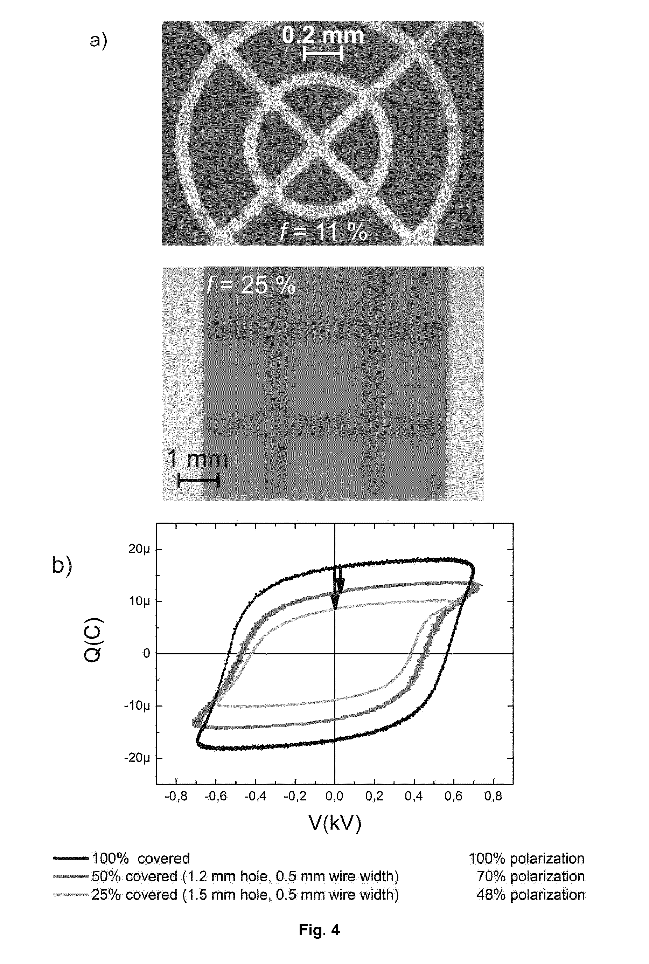

In order to characterize the polarization of the sample, the polarization measurements were performed using an assembly known in the art as Sawyer-Tower type. Samples were fabricated with varying coverage of the catalyst surface by the conducting material in a grid-like geometrical fashion (Figure 4a). The polarization study revealed (Figure 4b) that the measured polarization decreases more than 1-*f* for all measured samples (0%, 50% and 75% surface exposure percentages), which is a clear indication that there was polarization switching not only underneath the conducting material but also in the regions free from conducting material regions.

### Example 4. Characterization of the catalytic activity of the active material in the absence of polarization effects

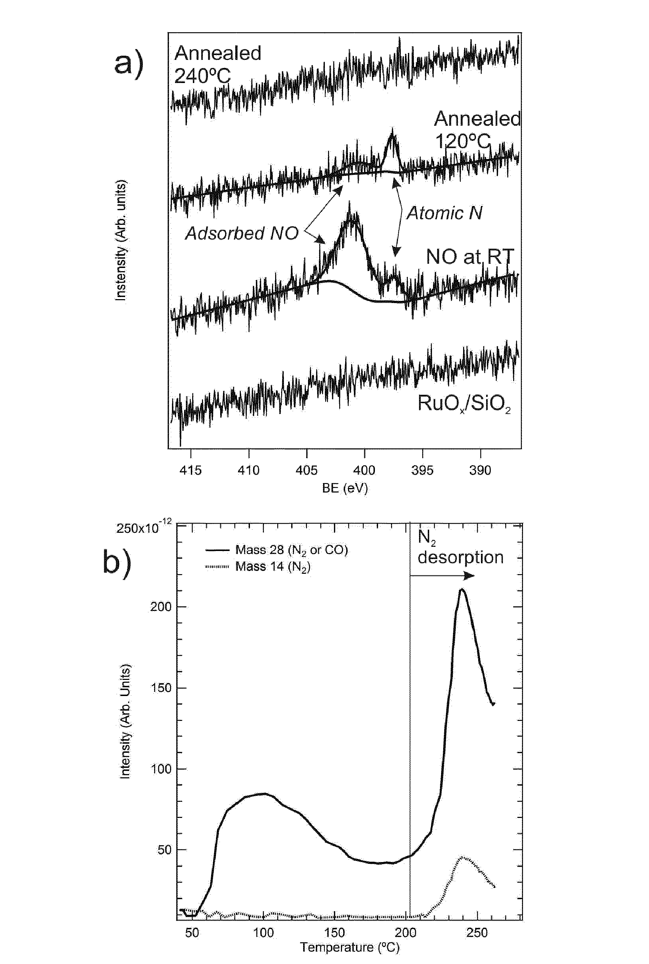

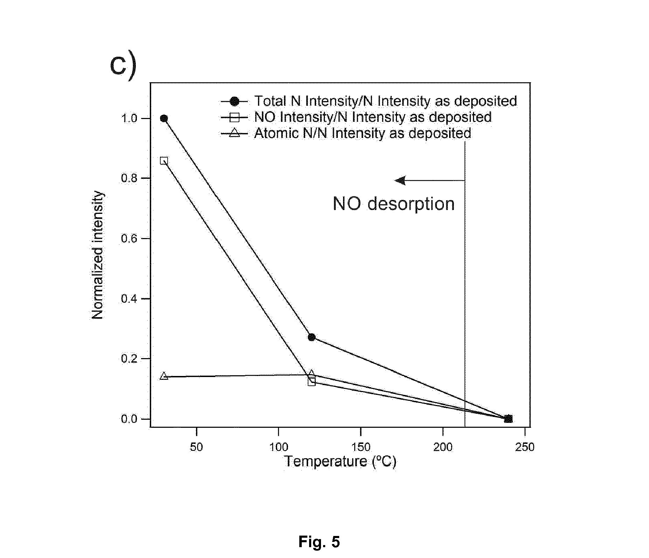

To gain an insight into the natural chemical reduction pathway of NOₓ on the active material in the absence of polarization effects, a sample was fabricated which consisted in silicon as a dielectric substrate on top of which a 50 nm thick layer of RuOₓ was deposited. The fabrication method followed the same procedure as that described in example 1. NO was then adsorbed on the RuOₓ layer, and the chemical state of the adsorbates was followed by inspection of the N1s core level by XPS as a function of the annealing treatments. As shown in Figure 5a, the spectrum corresponding to a sample exposed to 100 L of NO at room temperature shows two peaks at binding energies of 401.1 eV and 397.3 eV, corresponding to N atoms in intact NO molecules adsorbed on RuOx, and N atoms resulting from the dissociation of some NO molecules respectively. Annealing to 120°C leads to a large decrease in the intensity of the molecular species and a slight increase in the atomic nitrogen contribution, indicating a partial dissociation of NO molecules due to the annealing, and an overall decrease in the total N1s intensity of 70 %, which must be attributed to desorption of either intact NO molecules or N₂ reaction products. In order to distinguish the nature of the desorbed species, we have performed TPD spectra for masses 28 and 14 (Figure 5b), since mass 28 can also appear because of CO desorption from the sample holder walls upon annealing. The results show an onset for N₂ desorption at 200°C, demonstrating that the observed desorption at 120°C corresponds to intact NO molecules. Moreover, XPS spectra recorded after an annealing to 240°C shows no nitrogen present at the surface (Figure 54c). These experiments demonstrate that in the absence of polarization, RuOₓ films are not good catalysts for the reduction of NO, since the weak interaction between the NO molecules and RuOₓ promotes desorption versus dissociation, thereby reducing the yield of the reaction.

### Example 5. Characterization of the catalytic activity as a function of the polarization

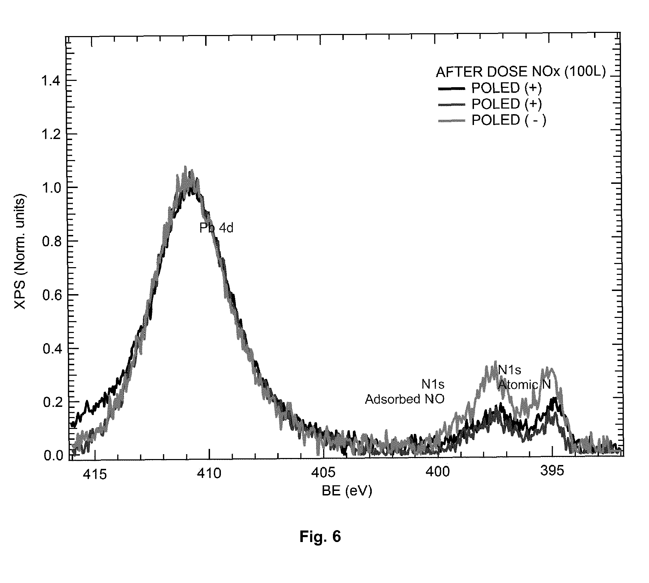

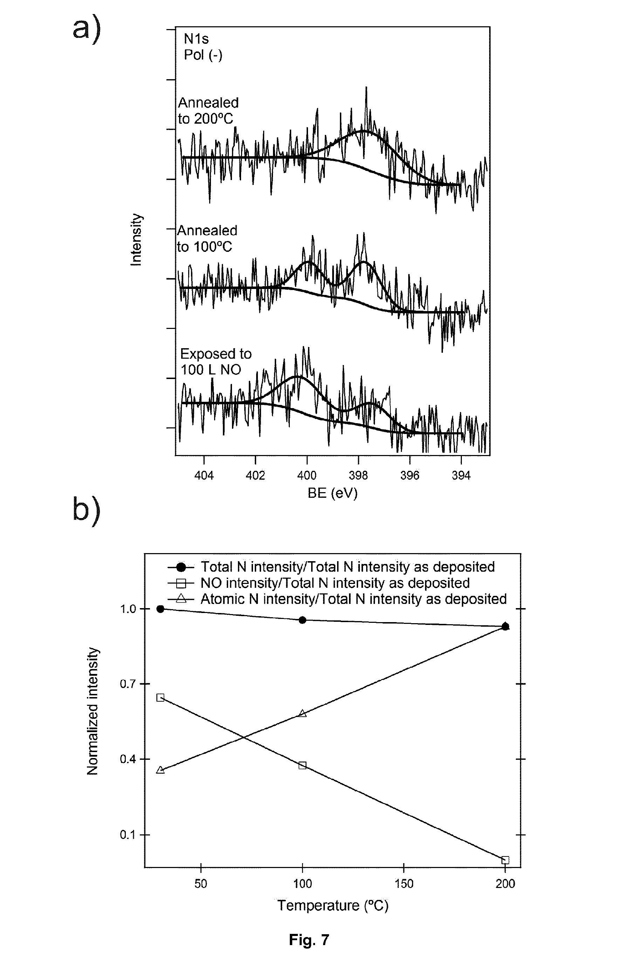

The effect that the polarization of the PZT substrate has on the catalyst activity was studied by means of XPS. Figure 6 shows normalized XPS of positively (+)PZT, and negatively, (-)PZT polarized samples submitted to 100 L of NO gas. The intensity of the two peaks associated to the adsorbed NO gas and the adsorbed N atoms (resulting from the dissociation of NO gas) is higher for (-)PZT samples. This result indicates that the catalyst surface in (-)PZT samples is a better adsorber of NO gas than the very same catalyst surface in (+)PZT samples, and therefore that the interaction between NO and RuOₓ is significantly enhanced by the presence of a negative polarization. In addition, XPS analysis (Figure 7a) for samples subjected to annealing processes at different temperatures reveals that the RuOₓ surface in the (-)PZT sample is more efficient in dissociating NO molecules than the RuOx surface in the absence of polarization effects. This is clear from Figure 7b, where the total amount of nitrogen on the sample remains almost constant (indicating that the desorption of intact NO molecules is below 5%), while all the molecular nitrogen is converted into atomic nitrogen.

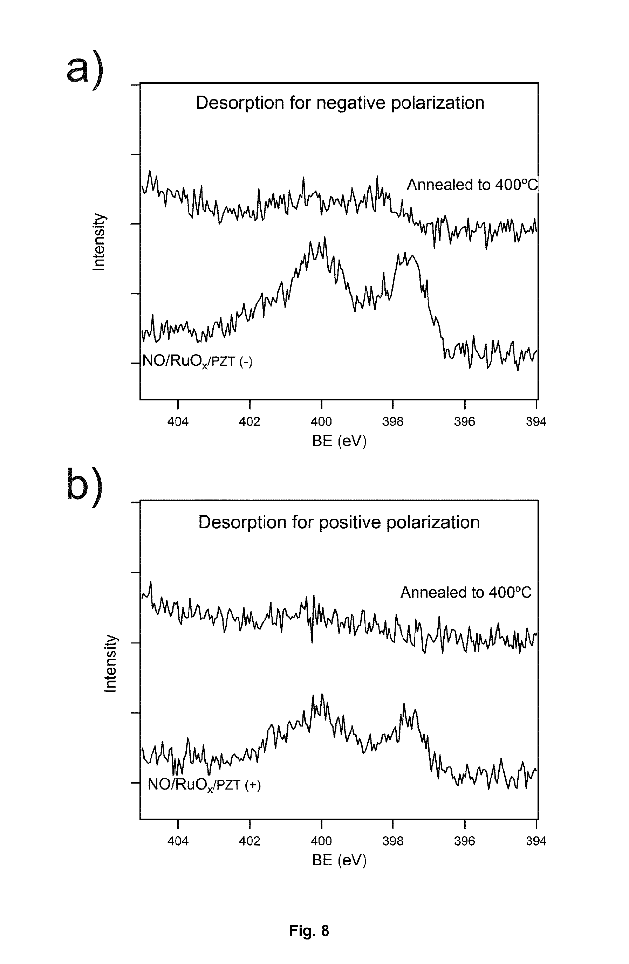

We have thus demonstrated that RuOx/(-)PZT efficiently promotes NO dissociation because of an enhanced interaction between NO and RuOₓ, but this could also hinder the desorption step in the catalytic reaction, during which N₂ should desorb from the catalyst surface to avoid poisoning. Indeed, the XPS results shown in Figure 8a demonstrate that, even after annealing to 400°C, a sizeable amount of nitrogen is still observed in the RuOx/(-)PZT sample. This problem is however solved by switching the polarity of the catalyst: Figure 8b shows that the N1s XPS peak for RuOₓ/(+)PZT vanishes after annealing to 400°C. We thus conclude that RuOₓ/PZT can act as a very efficient tunable catalyst for the reduction of nitrogen oxides, promoting reactant dissociation at negative polarity and product desorption at positive polarity.

## Claims

1. A catalyst device (1) comprising:
- a ferroelectric material substrate (2) comprising one first surface (2.1) opposed to a second surface (2.2),
- a conducting material layer (3) deposited on the first surface (2.1) of the ferroelectric material substrate (2),
- a catalyst material layer (4) deposited on the second surface (2.2) of the ferroelectric material substrate (2), said catalyst material layer (4) comprising an outer surface (4.1),
wherein the catalyst device is **characterized by** further comprising:
- a conducting material (5) covering between 10% and 75% of the outer surface (4.1) of the catalyst material layer (4), based on the total outer surface (4.1) of the catalyst material layer (4), and wherein the distance between any point in the outer surface (4.1) of the catalyst material layer (4) that is not covered by conducting material (5) and the closest point in the outer surface (4.1) of the catalyst material layer (4) that is covered with conducting material (5) is equal to or shorter than 1 mm.

2. The catalyst device according to claim 1, wherein there is at least one point in the outer surface (4.1) of the catalyst material layer (4) that is free from conducting material (5) that is at a distance of at least 0.5 micrometers from the closest point in the outer (4.1) surface of the catalyst material layer (4) that is covered with conducting material (5).

3. The catalyst device according to any one of claims 1 or 2, wherein the distance between any point in the outer surface (4.1) of the catalyst material layer (4) that is free from conducting material (5) and the closest point in the outer surface (4.1) of the catalyst material layer (4) covered with conducting material (5) is shorter than 500 micrometers.

4. The catalyst device according to any one of claims 1 to 3, wherein the conducting material (5) covering between 10% and 75% of the outer surface (4.1) of the catalyst material layer (4) is arranged in a regular pattern.

5. The catalyst device according to any one of claims 1 to 4, wherein the conducting material (5) covering between 10% and 75% of the outer surface (4.1) of the catalyst material layer (4) is arranged in the form of a grid, a spiral, a serpentine, a plurality of interconnected islands, a plurality of interconnected rows, a plurality of interconnected concentric circles a plurality of interconnected concentric polygons or a plurality of interconnected lines.

6. The catalyst device according to claim 5, wherein the conducting material (5) covering between 10% and 75% of the outer surface (4.1) of the catalyst material layer (4) is arranged in the form of a square grid, a rectangular grid, a triangular grid, a hexagonal grid, a diamond-shaped grid, a curvilinear grid or a linear grid.

7. The catalyst device according to claim 6, wherein each of the areas of the outer surface (4.1) of the catalyst material layer (4) that is not covered by conducting material (5) has a surface between 1000 µm² and 4 mm².

8. The catalyst device according to any one of claims 1 to 7, wherein the conducting material (5) covering between 10% and 75% of the outer surface (4.1) of the catalyst material layer (4) has a thickness between 20 and 200 nanometers.

9. The catalyst device according to any one of claims 1 to 8, wherein the catalyst material in the catalyst material layer (4) is a metal oxide, preferably a transition metal oxide.

10. The catalyst device according to claim 9, wherein the metal oxide is selected from RuO₂, CrO₂, Cr₂O₃, Al₂O₃, PtO₂, RhO₂, MnO₂, IrO₂, NiO₂, ZrO₂, V₂O₅, SrTiO₃, SrRuO₃, and combinations thereof.

11. The catalyst device according to any one of claims 1 to 10, wherein the ferroelectric material in the ferroelectric material substrate (2) is selected from Pb(Zr,Ti)O₃, PbTiO₃, BaTiO₃, (Ba,Sr)TiO₃, SrTiO₃, LiNbO₃, LiTaO₃, (Pb,La)(Zr,Ti)O₃, BiFeO₃, and combinations thereof.

12. The catalyst device according to claim 11, wherein the ferroelectric material in the ferroelectric material substrate (2) is Pb(Zr,Ti)O₃.

13. The catalyst device according to any one of claims 1 to 12, wherein the conducting material in the conducting material layer (3) deposited on the first surface (2.1) of the ferroelectric material substrate (2) and the conducting material (5) covering between 10% and 75% of the outer surface (4.1) of the catalyst material layer (4) are independently selected from Au, Pt, Ag, Cu, Al, Zn, Ni, Cr, V, Ti, Pd, Rh, Ru, Fe and combinations thereof.

14. The catalyst device according to any one of claims 1 to 13, wherein the conducting material layer (3) deposited on the first surface (2.1) of the ferroelectric material substrate (2) and the catalyst material layer (4) deposited on the second surface (2.2) of the ferroelectric material substrate (2) substantially cover the entire first surface (2.1) and second surface (2.2), respectively, of the ferroelectric material substrate (2).

15. Use of the catalyst device according to any one of claims 1 to 14 for reduction or elimination of nitrogen oxides.
